# EUROPEAN PATENT APPLICATION

(11) **EP 4 020 538 A2**
(43) Date of publication of application: **29.06.2022**
(21) Application number: 21210278.4
(22) Date of filing: 24.11.2021
(51) Int. Cl.: H01L 21/8238, H01L 21/28, H01L 27/092, H01L 29/10, H01L 29/165

(54) **SOURCE & DRAIN DOPANT DIFFUSION BARRIERS FOR N-TYPE GERMANIUM TRANSISTORS**

(30) Priority: 23.12.2020 US 202017133079
(71) Applicant: INTEL Corporation, Santa Clara, CA 95054 (US)
(72) Inventor: GANGULY, Koustav, Beaverton, 97006 (US); KEECH, Ryan, Portland, 97209 (US); Kennel, Harold W., Portland, 97223 (US); RACHMADY, Willy, Beaverton, 97007 (US); AGRAWAL, Ashish, Hillsboro, 97124 (US); GLASS, Glenn A., Portland, 97229 (US); MURTHY, Anand S., Portland, 97229 (US); KAVALIEROS, Jack T., Portland, 97229 (US)
(74) Representative: 2SPL Patentanwälte PartG mbB

(57) **Abstract**

High-purity Ge channeled N-type transistors (101) include a Si-based barrier material (115) separating the channel from a Ge source and drain (140) that is heavily doped with an N-type impurity. The barrier material may have nanometer thickness and may also be doped with N-type impurities. Because of the Si content, N-type impurities have lower diffusivity within the barrier material and can be prevented from entering high-purity Ge channel material. In addition to Si, a barrier material may also include C. With the barrier material, an N-type transistor may display higher channel mobility and reduced short-channel effects.

## Description

### BACKGROUND

Efforts to extend Moore's law for integrated circuitry (IC) have included development of transistors employing materials other than silicon (Si), such as Germanium (Ge) channel devices. Ge, as a material, offers higher charge carrier (electron and hole) mobility than silicon. Transistors with Ge channels should therefore be significantly faster than conventional Si channeled devices. However, Ge-channeled transistors, particularly N-type transistors, have not yet achieved compelling levels of performance. For example, N-type Ge field effect transistors (FETs) have displayed poor Vₜ control and significant short channel effects. Also, drive currents, transconductance, and other transistor performance metrics dependent upon electron mobility need to be improved.

Accordingly, transistor architectures and fabrication techniques that can address such performance issues will enhance the commercial value of Ge transistors.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements. In the figures:
FIG. 1 is a plan view of complementary metal-oxide-semiconductor (CMOS) circuitry including a Ge N-Type FET and a Ge P-Type FET over adjacent regions of a substrate, in accordance with some embodiments;
FIG. 2 illustrates an isometric sectional view through a source/drain of a Ge N-Type FET and through a Ge P-Type FET over adjacent regions of a substrate, in accordance with some embodiments;
FIG. 3 is a flow diagram of methods 301 for fabricating a Ge N-Type FET and a Ge P-Type FET, in accordance with some embodiments;
FIG. 4A, 5A and 6A are cross-sectional views of a Ge N-Type FET evolving as the methods illustrated in FIG. 3 are practiced, in accordance with some embodiments;
FIG. 4B, 5B and 6B are cross-sectional views of a Ge P-Type FET evolving as the methods illustrated in FIG. 3 are practiced, in accordance with some embodiments;
FIG. 7 illustrates a mobile computing platform and a data server machine employing an IC that includes a Ge N-Type FET and a Ge P-Type FET, in accordance with some embodiments; and
FIG. 8 is a functional block diagram of an electronic computing device, in accordance with some embodiments.

### DETAILED DESCRIPTION

Embodiments are described with reference to the enclosed figures. While specific configurations and arrangements are depicted and discussed in detail, it should be understood that this is done for illustrative purposes only. Persons skilled in the relevant art will recognize that other configurations and arrangements are possible without departing from the spirit and scope of the description. It will be apparent to those skilled in the relevant art that techniques and/or arrangements described herein may be employed in a variety of other systems and applications other than what is described in detail herein.

Reference is made in the following detailed description to the accompanying drawings, which form a part hereof and illustrate exemplary embodiments. Further, it is to be understood that other embodiments may be utilized and structural and/or logical changes may be made without departing from the scope of claimed subject matter. It should also be noted that directions and references, for example, up, down, top, bottom, and so on, may be used merely to facilitate the description of features in the drawings. Therefore, the following detailed description is not to be taken in a limiting sense and the scope of claimed subject matter is defined solely by the appended claims and their equivalents.

In the following description, numerous details are set forth. However, it will be apparent to one skilled in the art, that embodiments may be practiced without these specific details. In some instances, well-known methods and devices are shown in block diagram form, rather than in detail, to avoid obscuring the embodiments. Reference throughout this specification to "an embodiment" or "one embodiment" or "some embodiments" means that a particular feature, structure, function, or characteristic described in connection with the embodiment is included in at least one embodiment. Thus, the appearances of the phrase "in an embodiment" or "in one embodiment" or "some embodiments" in various places throughout this specification are not necessarily referring to the same embodiment. Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

As used in the description and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items.

The terms "coupled" and "connected," along with their derivatives, may be used herein to describe functional or structural relationships between components. It should be understood that these terms are not intended as synonyms for each other. Rather, in particular embodiments, "connected" may be used to indicate that two or more elements are in direct physical, optical, or electrical contact with each other. "Coupled" may be used to indicated that two or more elements are in either direct or indirect (with other intervening elements between them) physical or electrical contact with each other, and/or that the two or more elements co-operate or interact with each other (e.g., as in a cause and effect relationship).

The terms "over," "under," "between," and "on" as used herein refer to a relative position of one component or material with respect to other components or materials where such physical relationships are noteworthy. For example in the context of materials, one material or layer over or under another may be directly in contact or may have one or more intervening materials or layers. Moreover, one material between two materials or layers may be directly in contact with the two materials/layers or may have one or more intervening materials/layers. In contrast, a first material or layer "on" a second material or layer is in direct physical contact with that second material/layer. Similar distinctions are to be made in the context of component assemblies.

As used throughout this description, and in the claims, a list of items joined by the term "at least one of' or "one or more of' can mean any combination of the listed terms. For example, the phrase "at least one of A, B or C" can mean A; B; C; A and B; A and C; B and C; or A, B and C.

Described below are transistor architectures and fabrication techniques that improve the performance of Ge-channel transistors, particularly N-type transistors. The inventors have noted that N-type impurity diffusivity within a solid solution of Ge is much higher than for Si, particularly where Ge is of highest possible purity. High diffusivity of impurities is therefore particularly detrimental for transistors designed for highest carrier mobility that would otherwise benefit from a channel of highest possible purity (as opposed to a counter doped channel). The inventors have determined a high diffusivity of source/drain dopants, particularly the N-type impurities, and more particularly P, within Ge can significantly degrade channel material initially having high-purity. This channel degradation is manifested in more severe short channel effects, poorer Vt control and lower drive current and/or transconductance.

Upon identifying this issue, the inventors sought to avoid merely reducing the impurity dopant concentrations within the source and drain material, and instead introduce a barrier material layer into the transistor structure. The barrier material layer separates, or spaces apart, the channel from a source and drain that is heavily doped with an N-type impurity. The barrier material comprises primarily Si, which has been found to reduce diffusive encroachment of the n-type impurities into the high-purity Ge channel material. In some embodiments, the barrier material layer may include a secondary Group IV constituent such as C (*i.e.,* Si:C). Although the presence of one or both of these Group IV constituents reduce impurity encroachment, the barrier material layer may also include Ge. However, if present in the barrier layer, lower chemical concentrations of Ge are more advantageous for reducing impurity encroachment. In confirmation of the effort, the inventors have found N-type transistors with a source/drain dopant diffusion barrier in accordance with embodiments herein to display higher channel mobility and reduced short-channel effects relative to comparable devices lacking the barrier.

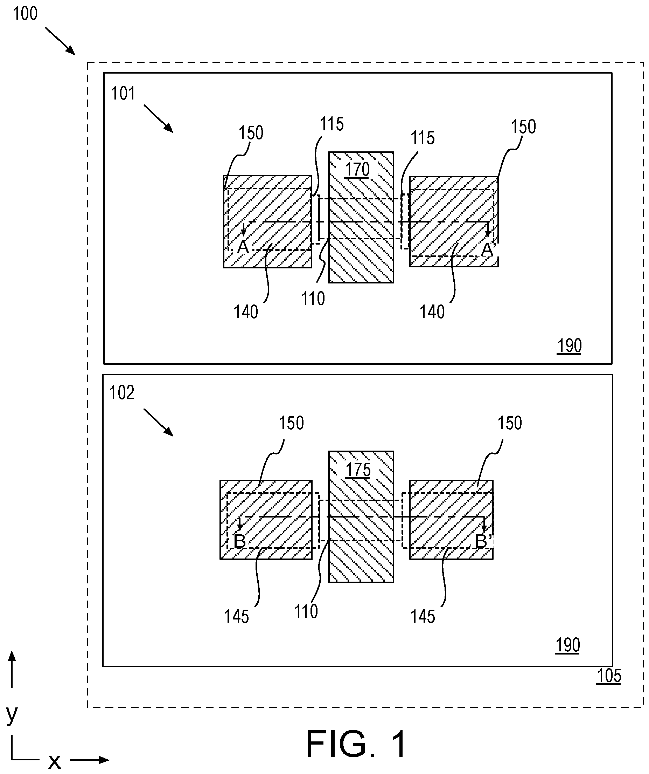

FIG. 1 is a plan view of complementary metal-oxide-semiconductor (CMOS) circuitry 100 including a Ge N-Type FET 101 and a Ge P-Type FET 102 over a substrate 105 and surrounded by an isolation material 180, in accordance with some embodiments. Depending on the implementation, substrate 105 may include substantially monocrystalline silicon or substantially monocrystalline germanium. Substrate 105 may also include other materials. For example, substrate 105 may be silicon on insulator (SOI), or germanium on insulator (GOI). Crystallographic orientation of monocrystalline material in substrate 105 may be any of (100), (111), or (110), for example. Isolation material 180 may be any material suitable for providing electrical isolation between transistors. In some exemplary embodiments, isolation material 180 is silicon dioxide. Other materials known to be suitable for the purpose of electrical isolation may also be utilized, including low-k materials (e.g., having a relative dielectric constant below 3.5).

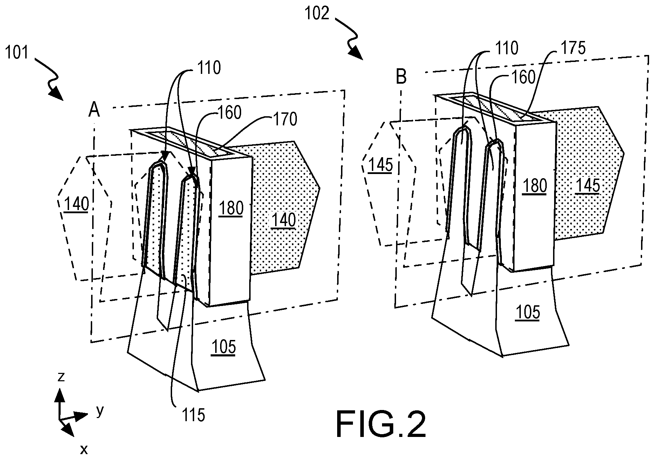

In FIG. 1, both of FETs 101 and 102 include a single fin of monocrystalline Ge channel material 110 over different regions of substrate 105. However, FETs 101 and 102 may each have more than one fin of channel material, and may further have any nanowire or nanoribbon architecture known in the art as embodiments are not limited in this context. For example, FIG. 2 illustrates an isometric sectional view of Ge N-Type FET 101 and Ge P-Type FET 102 in accordance with some alternative embodiments that have two fins of channel material 110.

In exemplary embodiments, channel material 110 is substantially pure Ge (as opposed to a SiGe alloy). Impurities within in channel material 110 are advantageously as low as possible (i.e., intrinsic) with preferably no intentional doping for highest carrier mobility. In exemplary embodiments, channel material 110 has a chemical impurity concentration of no more than 1e17 atoms/cm³ for both FETs 101 and 102. Although some defects may be present, channel material 110 is substantially monocrystalline, and may, for example, have the same orientation as that of monocrystalline material of substrate 105. Channel material 110 is below, and covered by, a gate stack. For N-type FET 101, the gate stack includes a gate electrode 170 including a suitable N-type workfunction metal. For P-type FET 102, the gate stack includes a gate electrode 175 including a suitable P-type workfunction metal.

As illustrated in FIG. 1, FETs 101 and 102 further include contact metallization 150, which may be any metallization suitable for making an electrical contact to heavily doped source and drain material. Contact metallization 150 may be the same composition for FETs 101 and 102, or may be specific to each of FETs 101 and 102. For N-type FET 101, contact metallization 150 is in direct physical contact with N-type source and drain material 140, which is electrically coupled to opposite ends of the channel material 110 through barrier material layer 115. For the sake of clarity, contact metallization 150 is not illustrated in FIG. 2.

N-type source and drain material 140 may comprise silicon and/or germanium (i.e., Si₁₋ₓGeₓ where x=0-1). In some exemplary embodiments, source and drain material 140 is predominantly (i.e., >50%) Ge. Source and drain material 140 may have no other Group IV chemical constituents (e.g., C) although source and drain material 140 is not necessarily precluded from having Group IV constituents other than Ge.

Source and drain material 140 comprises N-type (e.g., Group V) impurities. N-type source and drain material 140 includes N-type impurities, a portion of which are electrically active. In exemplary embodiments, the N-type impurities include at least one of P and As. In advantageous embodiments, the N-type impurities include P. For such embodiments, the N-type impurities may consist essentially of only P, or the N-type impurities may include both P and As. For the various types of N-type impurities that may be present, the total concentration of N-type impurities is advantageously at least 1e20atoms/cm³, more advantageously at least 5e20 atoms/cm³, and most advantageously 5e20-5e21 atoms/cm³ for lowest extrinsic resistance. Notably, these are chemical concentrations, and the concentration of electrically active impurities is somewhat lower. Although defect density may be higher than for channel material 110, source and drain material 140 is advantageously substantially monocrystalline, and may, for example, have the same orientation as that of channel material 110.

P-type FET 101 includes P-type source and drain material 145 that is electrically coupled to opposite ends of the channel material 110. In the absence of any barrier material, P-type source and drain material 145 is in direct contact with channel material 110. P-type source and drain material 145 may also comprise silicon and/or germanium (i.e., Si₁₋ₓGeₓ where x=0-1) with or without other Group IV constituents. P-type source and drain material 140 includes P-type impurities, a portion of which are electrically active. In exemplary embodiments, the P-type impurities include at least one of B, In, or Ga. In advantageous embodiments, the P-type impurities include B. For the various types of P-type impurities that may be present, the chemical concentration of P-type impurities is at least 5e20 atoms/cm³, and advantageously at least 1e21 atoms/cm³. Although defect density may again be higher in source and drain material 145 than for channel material 110, P-type source and drain material 145 is advantageously also substantially monocrystalline.

As noted above, N-type impurities have high rates of diffusion within a high-purity Ge channel material 110. Thus, for at least N-type FET 101, a dopant diffusion barrier material layer 115 separates channel material 110 from source and drain material 140. As further described below, barrier material layer 115 is of a composition distinct from that of channel material 110 and that of source/drain material 140. Advantageously, barrier material layer 115 includes Si, and spaces channel material 110 apart from the heavily doped source/drain material 140 by 1-10 nm. FET 102 lacks barrier material layer 115 in the recognition of P-type impurities having lower diffusivity than their N-type counterparts and therefore the advantages of introducing barrier material layer 115 may not balance the costs of doing so. In exemplary embodiments only N-type FET 101 includes barrier material layer 115, and the absence barrier material layer 115 in P-type FET 102 is helpful for illustrating attributes of barrier material layer 115. However, a P-type FET may alternatively also include an analogous P-type dopant barrier material layer.

As shown in FIG. 1 and 2, barrier material layer 115 is in direct contact with a sidewall of channel material 110. As shown in FIG. 2, barrier material layer 115 covers substantially the entirety of channel material 110 that is not covered by a gate stack further comprising gate electrode 170 and gate dielectric 160. In exemplary embodiments, barrier material layer 115 comprises Si. In some exemplary embodiments, silicon content within barrier material layer 115 is between 0.3 at. % and 100 at. %. Although the amount of silicon within barrier material layer 115 may vary, silicon content within barrier material 115 is generally greater than the silicon content within channel material 110 or N-type source and drain material 140. Relative to the high-purity channel material 110, the silicon content within barrier material layer 115 serves as a barrier or spacer within which diffusivity is lower for the N-type impurities present N-type source and drain material 140. Higher concentrations of silicon are therefore advantageous. Exemplary embodiments are therefore predominantly Si and may be at least 90 at. % Si. Embodiments where barrier material layer 115 is substantially pure silicon with only trace amounts of Ge may pose the formable barrier to diffusion of N-type impurities. Barrier material layer 115 advantageously substantially monocrystalline, and may, for example, have the same orientation as that of channel material 110. The thickness of barrier material layer 115 is therefore to be less than a critical thickness where relaxation will occur, which is a function of silicon content.

In accordance with some embodiments herein, barrier material layer 115 is intentionally doped with N-type impurities. However, in exemplary embodiments, N-type impurity concentration within barrier material layer 115 is lower than the N-type impurity concentration within N-type source and drain material 140. In exemplary embodiments, the concentration of N-type impurities within barrier material layer 114 is less than 5e20 atoms/cm³, advantageously more than 1e19 atoms/cm³, and most advantageously between 1e19- atoms/cm³ and 5e20 atoms/cm³, inclusive. An N-type impurity concentration gradient may also be present across the thickness of barrier material layer 115, for example as a result of impurity diffusion from source and drain material 140 into barrier material layer 115. The inventors have found however that marked improvements in transistor performance can be had even where barrier material layer 115 is no more than 10 nm in thickness, and for such thickness an impurity gradient may not be readily detectable with current analysis techniques. However, one or more of nanoanalysis techniques, such as, but not limited to, transmission electron micrograph (TEM) energy dispersive X-ray spectroscopy (EDS)/ energy loss spectroscopy (EELS), time of flight secondary ion mass spectroscopy (TOF-SIMS), or atom probe tomography (APT) may be enlisted to discern differences in the Group IV and Group V elemental concentrations across channel material 110, barrier material layer 115, and source and drain material 140.

In some embodiments, barrier material layer 115 further comprises carbon. The addition of carbon may further reduce diffusivity of N-type dopants within barrier material layer 115. In embodiments that include carbon, the carbon content is lower than the silicon content. For example, carbon content may advantageously be < 2 at. % (e.g., 0.1 at. % - 2 at. %).

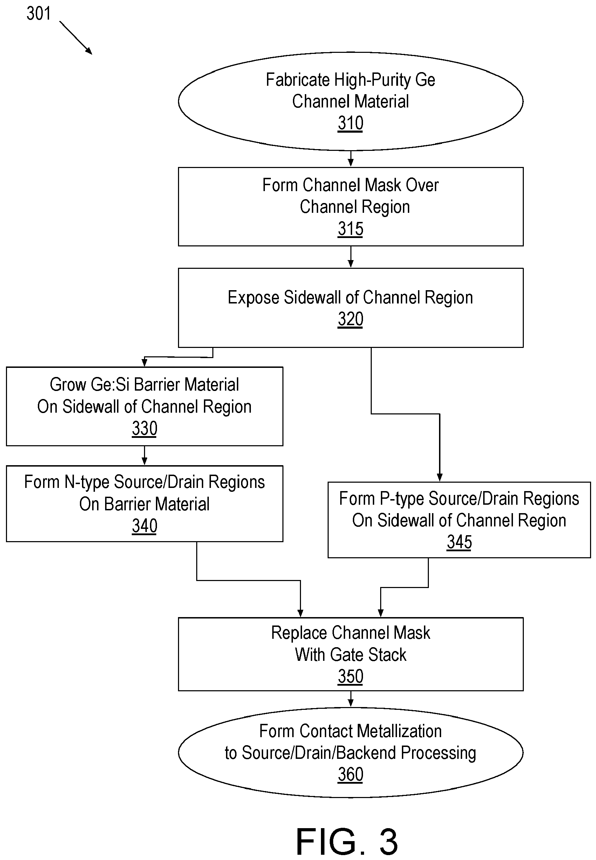

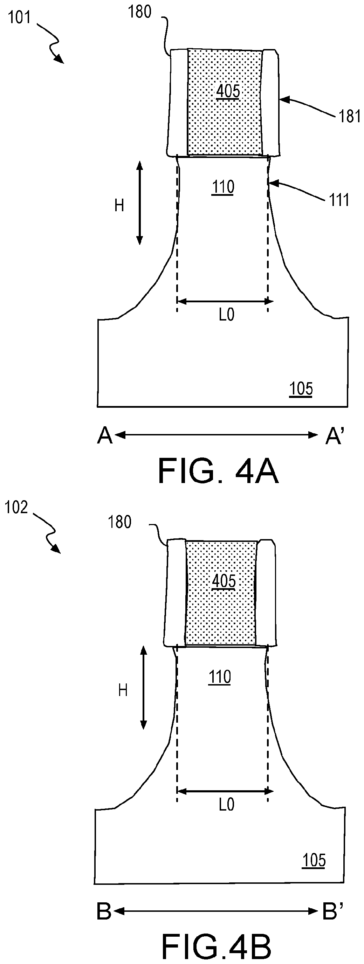

FIG. 3 is a flow diagram of methods 301 for fabricating a Ge N-Type FET and a Ge P-Type FET, in accordance with some embodiments. Methods 301 may be practiced, for example, to fabricated FETs 101 and 102 (FIG. 1-2), for example. FIG. 4A-6A are cross-sectional views of N-Type FET 101 evolving as the methods 300 are practiced, in accordance with some embodiments. FIG. 4B-6B are cross-sectional views of e P-Type FET 102 evolving as the methods 301 are practiced, in accordance with some embodiments. The cross-sectional views illustrated in FIG. 4A-6A are along the A plane depicted in FIG. 1 and FIG. 2. The cross-sectional views illustrated in FIG. 4B-6B are along the B plane depicted in FIG. 1 and FIG. 2.

Referring first to FIG. 3, methods 301 begin at operation 310 where a Ge channel material of high purity is fabricated. In some embodiments, any conventional subtractive patterning technique may be employed to delineate features from a blanket Ge film grown over, or transferred to, a surface of an underlying substrate. Methods 301 continue at operation 315 where a channel mask is patterned to protect a portion of the channel material that is to be retained under a gate stack. Any known masking technique(s) and material(s) may be employed at operation 315. In some embodiments, the channel mask is a gate mandrel retained through a number of processes until being replaced in a "gate-last" FET fabrication flow. Alternatively, in a "gate-first" FET fabrication flow the channel mask is a gate stack that is to be retained as a permanent feature of the FET. With the channel region protected, a sidewall of the channel region is exposed be removing unmasked channel material with any suitable Ge etch process(es).

In the exemplary embodiments illustrated in FIG. 4A and 4B, upon completion of block 320, both FETs 101 and 102 include channel material 110 under a channel mask that is composed of both a gate mandrel 405 and dielectric spacer 180. Channel material 110 has a channel width L0 over some z-height H. Channel width L0 and z-height H are defined by recess etching a predetermined amount of Ge from around the protected channel material 110. A combination of anisotropic (e.g., REI) etching and isotropic (e.g., wet chemical or dry plasma) etching may be practiced to achieve a desired channel width L0. In the embodiment illustrated in FIG. 4A, channel length L0 is smaller than a width of the channel mask such that channel material sidewall 111 is below dielectric spacer 180. In other words, channel material 110 is undercut slightly from a dielectric spacer sidewall 181. For comparison, both N-type FET 101 and P-type FET 102 have the same channel width L0 and z-height H. However, the channel widths and z-heights may instead vary between an N-type and a P-type FET.

Gate mandrel 405 may be any sacrificial material Any fabrication techniques may be employed to fabricate gate mandrel 405 so that it extends over channel material 110, and is adjacent to a portion of channel material sidewall 111 demarked by the dashed lines separated by channel length L0. Dielectric spacer 180 may be one or more material layer patterned by any conventional self-aligned spacer process to laterally stand-off subsequent materials from gate mandrel 405. For example, dielectric spacer 180 may be a dielectric (e.g., silicon dioxide and/or silicon nitride) that is conformally deposited over channel material 110, and over gate mandrel 405.

Returning to FIG. 3, methods 301 processing of the N-type and P-type transistors is separated. N-type transistor fabrication continues at block 330 where a layer of barrier material is epitaxially grown on sidewall surface(s) of the channel material not protected by the channel mask. Any epitaxially process, such as, but not limited to, molecular beam epitaxial (MBE), chemical vapor deposition (CVD)/atomic layer deposition (ALD), or hydride vapor phase epitaxy (HVPE) may be practiced at block 330 to grow any of the barrier materials se described above.

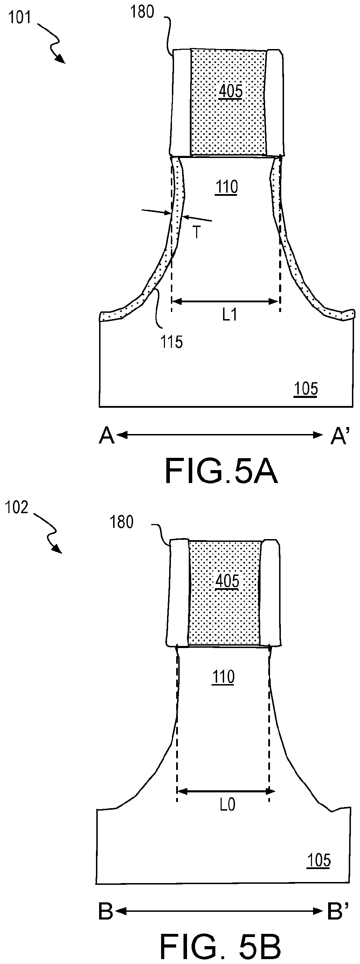

In some embodiments, the barrier material is grown with at least a silicon precursor and potentially also a germanium and/or carbon precursor. In some embodiments, the barrier material is grown with Si precursor (e.g., SiH₄) and one or more N-type impurity precursors (e.g., PH₃ and/or AsH₃). In exemplary embodiments, a crystalline film is epitaxially grown while the substrate is heated to 450-800 °C. In some further embodiments, a C precursor (e.g., any alkane/alkene) is also introduced. FIG. 5A illustrates an overgrowth of barrier layer material 115 having a thickness T. In exemplary embodiments, barrier layer material thickness T is 1-10 nm. For comparison, FIG. 5B illustrates P-type FET 102 as substantially unchanged indicating P-type FET 102 is masked during growth of barrier layer material 115.

Upon completing overgrowth of the barrier material layer, method 301 continues at block 340 where N-type source and drain material is epitaxially grown with the barrier material layer serving as a seeding surface. Likewise, P-type FET fabrication continues at block 345 where P-type source and drain material is epitaxially grown, but with the channel material serving as a seeding surface. The epitaxial growths at blocks 340 and 345 may be performed in any order while the complementary FET is protected with a growth mask.

At block 340 the epitaxially overgrowth initiated at block 330 is continued to form any of the crystalline films comprising Si_{1-*x*}Ge*ₓ* (x=0-1), which have more Ge than the barrier material layer, for example as described above. One or more N-type impurity precursors (e.g., PH₄ and/or AsH₃) are introduced along with the Ge precursor (e.g., GeH₄) to grow heavily N-type doped material. The silicon precursor enlisted in block 330 may be terminated, or at least reduced, at block 340. Substrate temperature may remain at 450-800 °C, for example. At block 345, any of the crystalline films comprising Ge (e.g., Si_{1-*x*}Ge*ₓ*) described above are grown by introducing a Ge precursor and one or more P-type precursors (e.g., BH₃ or B₂H₆) while the substrate is heated to 450-800 °C.

Returning to FIG. 3, methods 301 continue at operation 350 where the channel mask is replaced with a permanent gate stack. Method 301 is then substantially completed with any suitable contact metallization and backend processing performed at block 360.

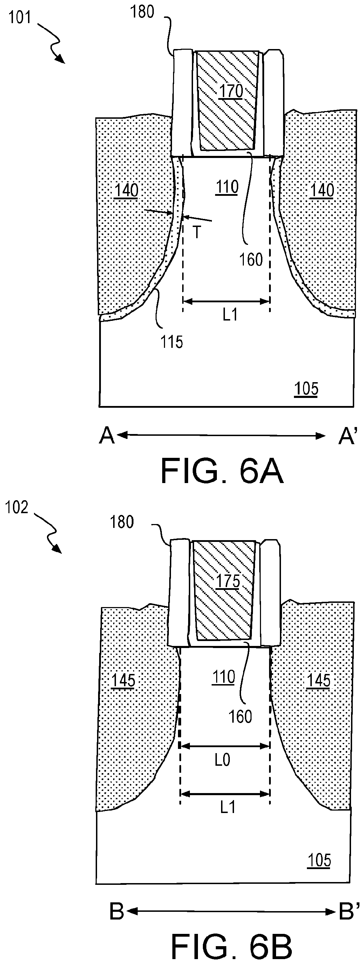

FIG. 6A and FIG. 6B further illustrate N-type FET 101 and P-type FET 102 after N-type source and drain material 140, and P-type source and drain material 145 has been grown and the gate mandrel replaced with a gate stack. As illustrated in FIG. 6A, an interface between barrier material layer 115 and channel material 110 defines a channel length L1 while an interface between P-type source and drain material 145 and channel material 110 defines a channel length L0. For reference, channel length L1 is shown in FIG. 6B being substantially equal to L0.

For N-type FET 101, the gate stack includes gate dielectric 160 and a gate electrode 170 including a first workfunction metal. For N-type FET 101, the gate stack includes gate dielectric 160 and a gate electrode 175 including a second workfunction metal. In exemplary embodiments, gate dielectric 160 comprises any known high-k material (e.g., having a bulk relative permittivity greater than 9).

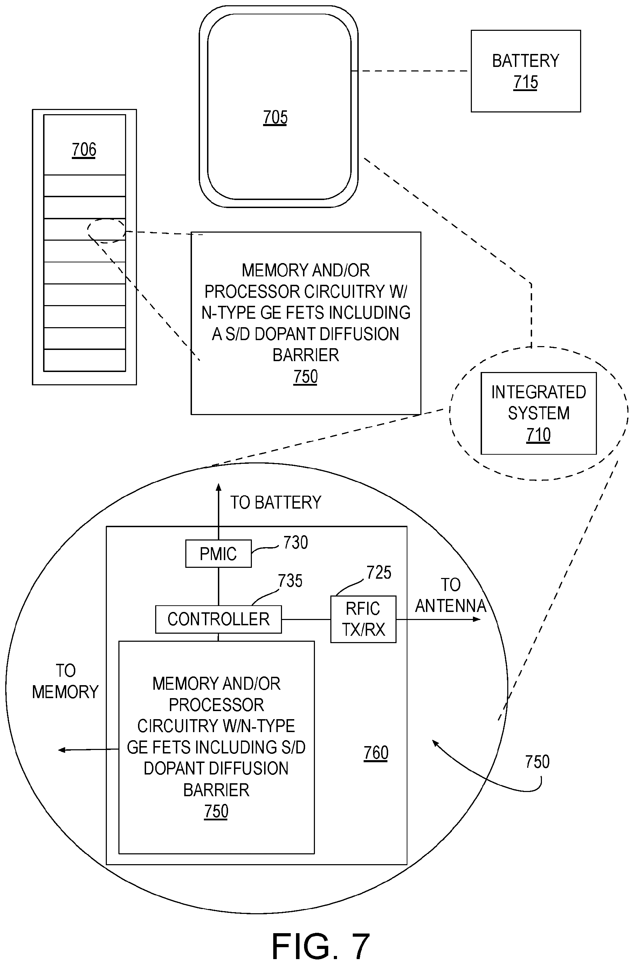

The transistor structures, and the methods of forming such structures described herein may be integrated into a wide variety of ICs and computing systems. FIG. 7 illustrates a system in which a mobile computing platform 705 and/or a data server machine 706 includes an IC 701 with N-type FETs that include a source/drain diffusion barrier, for example as described elsewhere herein. The server machine 706 may be any commercial server, for example including any number of high-performance computing platforms within a rack and networked together for electronic data processing, which in the exemplary embodiment includes a monolithic IC 701. The mobile computing platform 705 may be any portable device configured for each of electronic data display, electronic data processing, wireless electronic data transmission, or the like. For example, the mobile computing platform 705 may be any of a tablet, a smart phone, laptop computer, etc., and may include a display screen (e.g., a capacitive, inductive, resistive, or optical touchscreen), a chip-level integrated system 710, and a battery 715.

Whether disposed within the integrated system 710 illustrated in the expanded view 750, or as a stand-alone packaged chip within the server machine 706, IC 71 may include memory circuitry (e.g., RAM), and/or a logic circuitry (e.g., a microprocessor, a multi-core microprocessor, graphics processor, or the like). At least one of these circuitries includes with N-type FETs that include a source/drain diffusion barrier, for example as described elsewhere herein. IC 701 may be further coupled to a board or package substrate 760 that further hosts one or more additional ICs, such as power management IC 730 and radio frequency IC 725. RFIC 725 may have an output coupled to an antenna (not shown) to implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond.

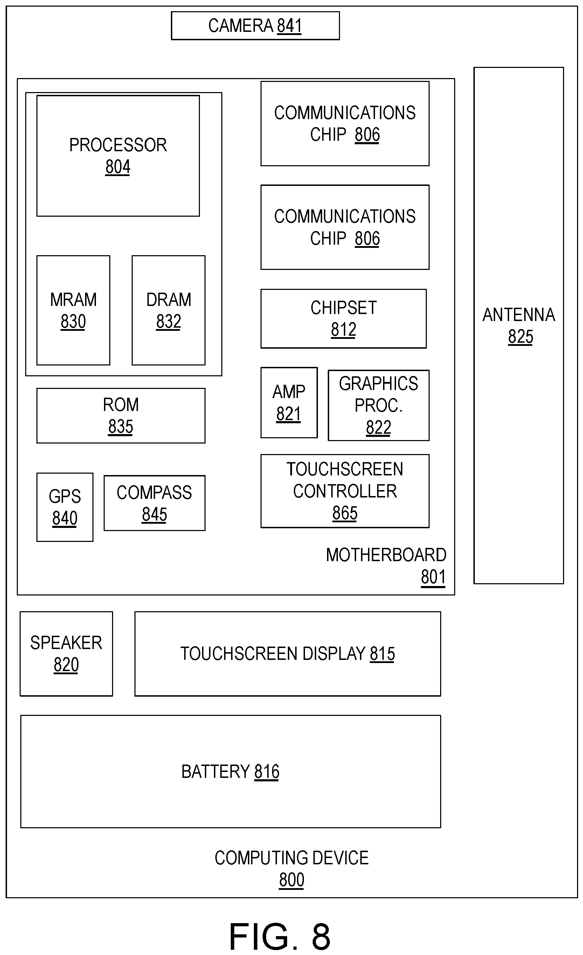

FIG. 8 is a functional block diagram of an electronic computing device 800, in accordance with some embodiments. Device 800 further includes a motherboard 801 hosting a number of components, such as, but not limited to, a processor 804 (e.g., an applications processor). Processor 804 may be physically and/or electrically coupled to motherboard 801. In some examples, processor 804 is part of a monolithic IC structure with N-type FETs that include a source/drain diffusion barrier, for example as described elsewhere herein. In general, the term "processor" or "microprocessor" may refer to any device or portion of a device that processes electronic data from registers and/or memory to transform that electronic data into other electronic data that may be further stored in registers and/or memory.

In various examples, one or more communication chips 806 may also be physically and/or electrically coupled to the motherboard 801. In further implementations, communication chips 806 may be part of processor 804. Depending on its applications, computing device 800 may include other components that may or may not be physically and electrically coupled to motherboard 801. These other components include, but are not limited to, volatile memory (e.g., DRAM 832), non-volatile memory (e.g., ROM 835), flash memory (e.g., NAND or NOR), magnetic memory (MRAM 830), a graphics processor 822, a digital signal processor, a crypto processor, a chipset 812, an antenna 825, touchscreen display 815, touchscreen controller 865, battery 816, audio codec, video codec, power amplifier 821, global positioning system (GPS) device 840, compass 845, accelerometer, gyroscope, speaker 820, camera 841, and mass storage device (such as hard disk drive, solid-state drive (SSD), compact disk (CD), digital versatile disk (DVD), and so forth, or the like.

Communication chips 806 may enable wireless communications for the transfer of data to and from the computing device 800. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. Communication chips 806 may implement any of a number of wireless standards or protocols, including, but not limited to, those described elsewhere herein. As discussed, computing device 800 may include a plurality of communication chips 806. For example, a first communication chip may be dedicated to shorter-range wireless communications, such as Wi-Fi and Bluetooth, and a second communication chip may be dedicated to longer-range wireless communications such as GPS, EDGE, GPRS, CDMA, WiMAX, LTE, and others.

While certain features set forth herein have been described with reference to various implementations, the description is not intended to be construed in a limiting sense. Hence, various modifications of the implementations described herein, as well as other implementations, which are apparent to persons skilled in the art to which the present disclosure pertains are deemed to lie within the spirit and scope of the present disclosure.

It will be recognized that this disclosure is not limited to the embodiments so described, but can be practiced with modification and alteration without departing from the scope of the appended claims. For example, the above embodiments may include specific combinations of features as further provided below.

In first examples, an integrated circuit (IC) comprises an N-type transistor comprising a first gate stack over a first channel material of substantially Ge, and having an impurity concentration of less than 1e17 atoms/cm³, and an N-type source material and an N-type drain material electrically coupled to opposite ends of the first channel material. The N-type source and drain material comprise Ge with an N-type impurity comprising least one of P or As. The N-type transistor comprises a barrier material layer between the first channel material and each of the N-type source material and the N-type drain material, wherein the barrier material layer comprises more Si than the first channel material, the N-type source material, and the N-type drain material, and has a lower concentration of the N-type impurity than the N-type source and drain material.

In second examples, for any of the first examples the IC further comprises a P-type transistor comprising a second gate stack over a second channel material of substantially Ge, and a P-type source material and a P-type drain material in direct contact with the second channel material. The P-type source material and the P-type drain material comprise at least one of B, In, or Ga.

In third examples, for any of the second examples the P-type source material and the P-type drain material comprise Ge, and the second channel material has an impurity concentration of less than 1e17 atoms/cm³.

In fourth examples, for any of the first through third examples a concentration of the N-type impurities within the N-type source material and the N-type drain material is at least 1e20 atoms/cm³, and the concentration of the N-type impurities within the barrier material layer is at least 1e19 atoms/cm³.

In fifth examples, for any of the first through fourth examples the concentration of the N-type impurities within the N-type source material and the N-type drain material is between 5e20 and 5e21 atoms/cm³.

In sixth examples, for any of the first through fifth examples the concentration of the N-type impurities within the barrier material layer is less than 1e20 atoms/cm³.

In seventh examples, for any of the fourth through sixth examples the barrier material layer is substantially Si, the barrier material layer has a thickness of 1-10 nm, and the barrier material layer is in direct contact with the channel material, the source material, and the drain material.

In eighth examples, for any of the first through seventh examples the barrier material layer further comprises 0.1-2.0 at. % C.

In ninth examples, for any of the eighth examples the barrier material layer comprises more Si than C.

In tenth examples, for any of the first through ninth examples the first channel material, the barrier material layer, the source material and the drain material are all substantially monocrystalline.

In eleventh examples, a system comprises a power supply, a processor coupled to the power supply, and a memory coupled to the processor. The processor or the memory comprises an N-type transistor. The N-type transistor comprises a first gate stack over a first channel material of substantially Ge, and having a total impurity concentration of less than 1e17 atoms/cm³. The transistor comprises an N-type source material and an N-type drain material coupled to opposite ends of the first channel material, wherein the N-type source material and the N-type drain material both comprise Ge with N-type impurities comprising least one of P or As. The transistor comprises a barrier material layer between the first channel material and each of the N-type source material and the N-type drain material. The barrier material layer comprises predominantly Si. The processor or memory comprises a P-type transistor. The P-type transistor comprises a second gate stack over a second channel material of substantially. The P-type transistor comprises a P-type source material and a P-type drain material in direct contact with the second channel material. The P-type source material and the P-type drain material comprising Ge with P-type impurities comprising at least one of B, In, or Ga.

In twelfth examples, for any of the eleventh examples a concentration of the N-type impurities within the N-type source material and the N-type drain material is at least 5e20 atoms/cm³, and the concentration of the N-type impurities within the barrier material layer is between 1e19 atoms/cm³ and 5e20 atoms/cm³.

In thirteenth examples, for any of the twelfth examples, the barrier material layer has a thickness of 1-10 nm; and the barrier material layer is in direct contact with the channel material, the source material, and the drain material.

In fourteenth examples, for any of the twelfth through thirteenth examples the system comprises a battery coupled to the power supply.

In fifteenth examples, a method comprises receiving a substrate including a channel material over a first region of the substrate, wherein the channel material is substantially Ge with an impurity concentration no more than 1e17 atoms/cm³. The method comprises epitaxially growing a barrier material layer upon a sidewall surface of the channel material, wherein the barrier layer comprise growing a crystalline film comprising predominantly Si. The method comprises epitaxially growing a source and drain material comprising Ge upon a surface of the barrier material layer, wherein growing the source and drain material comprises an in-situ doping with one or more N-type impurity to a chemical concentration of at least 5e20 atoms/cm³. The method comprises forming a gate stack over the channel material between separate portions of the source and drain material.

In sixteenth examples, for any of the fifteenth examples epitaxially growing the source and drain material further comprises heating the substrate to 450-800 °C and introducing precursors of Si, Ge and at least P.

In seventeenth examples, for any of the fifteenth through sixteenth examples epitaxially growing the source and drain material further comprises introducing a precursor of As.

In eighteenth examples, for any of the fifteen through sixteenth examples growing of the source and drain material is with less Si precursor than the growing of the barrier material layer.

In nineteenth examples, for any of the fifteenth through eighteenth examples epitaxially growing the barrier material layer further comprises heating the substrate to 450-800 °C and introducing precursor Si with an N-type impurity precursor.

In twentieth examples, for any of the fifteenth through nineteenth examples the substrate further comprises the channel material within a second region of the substrate, and the method further comprise epitaxially growing a second source and drain material comprising Ge upon a sidewall of channel material within the second region in-situ doping with one or more P-type impurities, and forming a second gate stack over the channel material between separate portions of the second source and drain material.

However, the above embodiments are not limited in this regard and, in various implementations, the above embodiments may include the undertaking of only a subset of such features, undertaking a different order of such features, undertaking a different combination of such features, and/or undertaking additional features than those features explicitly listed.

## Claims

1. An integrated circuit (IC), comprising an N-type transistor, wherein the N-type transistor comprises:
a first gate stack over a channel material of substantially Ge, and having an impurity concentration of less than 1e17 atoms/cm³;
an N-type source material and an N-type drain material electrically coupled to opposite ends of the channel material, wherein the N-type source and drain material comprise Ge with an N-type impurity comprising least one of P or As; and
a barrier material layer between the channel material and each of the N-type source material and the N-type drain material, wherein the barrier material layer comprises more Si than the channel material, the N-type source material, and the N-type drain material, and has a lower concentration of the N-type impurity than the N-type source and drain material.

2. The IC of claim 1, further comprising a P-type transistor, wherein the P-type transistor comprises:
a second gate stack over a second channel material of substantially Ge; and
a P-type source material and a P-type drain material in direct contact with the second channel material, wherein the P-type source material and the P-type drain material comprise at least one of B, In, or Ga.

3. The IC of claim 2, wherein:
the P-type source material and the P-type drain material comprise Ge; and
the second channel material has an impurity concentration of less than 1e17 atoms/cm³.

4. The IC of any one of claims 1-3, wherein:
a concentration of the N-type impurities within the N-type source material and the N-type drain material is at least 1e20 atoms/cm³; and
the concentration of the N-type impurities within the barrier material layer is at least 1e19 atoms/cm³.

5. The IC of claim 4, wherein:
the concentration of the N-type impurities within the N-type source material and the N-type drain material is between 5e20 and 5e21 atoms/cm³.

6. The IC of claim 5, wherein the concentration of the N-type impurities within the barrier material layer is less than 1e20 atoms/cm³.

7. The IC of any one of claims 4-6, wherein:
the barrier material layer is substantially Si;
the barrier material layer has a thickness of 1-10 nm; and
the barrier material layer is in direct contact with the channel material, the source material, and the drain material.

8. The IC any one of claims 1-7, wherein the barrier material layer further comprises 0.1-2.0 at. % C.

9. The IC of claim 8, wherein the barrier material layer comprises more Si than C.

10. The IC any one of claims 1-9, wherein the channel material, the barrier material layer, the source material and the drain material are all substantially monocrystalline.

11. A system comprising:
a power supply;
a processor coupled to the power supply; and
a memory coupled to the processor, wherein the processor or the memory comprises a an N-type transistor, and wherein the N-type transistor comprises:
a first gate stack over a first channel material of substantially Ge, and having a total impurity concentration of less than 1e17 atoms/cm³;
an N-type source material and an N-type drain material coupled to opposite ends of the first channel material, wherein the N-type source material and the N-type drain material both comprise Ge with N-type impurities comprising least one of P or As; and
a barrier material layer between the first channel material and each of the N-type source material and the N-type drain material, wherein the barrier material layer comprises predominantly Si, and
a P-type transistor, wherein the P-type transistor comprises:
a second gate stack over a second channel material of substantially Ge; and
a P-type source material and a P-type drain material in direct contact with the second channel material, wherein the P-type source material and the P-type drain material comprising Ge with P-type impurities comprising at least one of B, In, or Ga.

12. The system of claim 11, wherein:
a concentration of the N-type impurities within the N-type source material and the N-type drain material is at least 5e20 atoms/cm³; and
the chemical concentration of the N-type impurities within the barrier material layer is between 1e19 atoms/cm³ and 5e20 atoms/cm³.

13. The system of claim 12, wherein:
the barrier material layer has a thickness of 1-10 nm; and
the barrier material layer is in direct contact with the channel material, the source material, and the drain material.

14. The system any one of claims 11-13, further comprising a battery coupled to the power supply.

15. A method comprising:
receiving a substrate including a channel material over a region of the substrate, wherein the channel material is substantially Ge with an impurity concentration no more than 1e17 atoms/cm³;
epitaxially growing a barrier material layer upon a sidewall surface of the channel material, wherein the barrier layer comprise growing a crystalline film comprising predominantly Si;
epitaxially growing a source and drain material comprising Ge upon a surface of the barrier material layer, wherein growing the source and drain material comprises an in-situ doping with one or more N-type impurity to a chemical concentration of at least 5e20 atoms/cm3; and
forming a gate stack over the channel material between separate portions of the source and drain material.
